(19) Europäisches Patentamt
European Patent Office
Office européen des brevets

(11) EP 3 904 417 A1

(12) **EUROPEAN PATENT APPLICATION**
published in accordance with Art. 153(4) EPC

(43) Date of publication:
**03.11.2021 Bulletin 2021/44**

(21) Application number: **19906119.3**

(22) Date of filing: **23.12.2019**

(51) Int Cl.:
***C08G 59/20*** *(2006.01)* ***H01L 23/29*** *(2006.01)*
***H01L 23/31*** *(2006.01)* ***C08L 63/00*** *(2006.01)*
***H01L 21/56*** *(2006.01)*

(86) International application number:
**PCT/JP2019/050401**

(87) International publication number:
**WO 2020/137989 (02.07.2020 Gazette 2020/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.12.2018 JP 2018244444**

(71) Applicant: **Sumitomo Bakelite Co.Ltd.**
**Shinagawa-ku**
**Tokyo 140-0002 (JP)**

(72) Inventor: **KAWAMURA, Shinya**
**Tokyo 140-0002 (JP)**

(74) Representative: **Müller-Boré & Partner Patentanwälte PartG mbB**
**Friedenheimer Brücke 21**
**80639 München (DE)**

(54) **RESIN COMPOSITION FOR SEALING, SEMICONDUCTOR DEVICE, AND PRODUCTION METHOD FOR SEMICONDUCTOR DEVICE**

(57) According to the present invention, there is provided a resin composition for sealing containing (A) an epoxy resin; (B) a curing agent; and (C) a filler, wherein the epoxy resin (A) includes an epoxy resin (A-1) having a naphthyl ether skeleton, and wherein the resin composition for sealing satisfies the following Formula (1) : Formula

$$(1)\ E_2 \times (\alpha_2 \times 10^{-6}) \times (175 - Tg) \times \eta_2 \leq 0.3$$

wherein, in Formula (1), Tg (°C) is a glass transition temperature of a cured product of the resin composition for sealing,
$\alpha_2$ (ppm/°C) is a coefficient of linear expansion over a range from 190°C to 230°C of the cured product, and
$E_2$ (MPa) is a hot elastic modulus at 260°C of the cured product, and
$\eta_2$ (MPa) is a rectangular pressure at 175°C of the resin composition for sealing as measured by the following method;
(method)
the resin composition for sealing is injected, using a low-pressure transfer molding machine, into a rectangular-shaped flow channel having a width of 15 mm, a thickness of 1 mm, and a length of 175 mm under conditions of a mold temperature of 170°C and an injection flow rate of 177 $mm^3$/sec, a change in pressure over time is measured with a pressure sensor embedded at a position 25 mm away from an upstream tip of the flow channel, a lowest pressure (MPa) during a flow of the resin composition for sealing is measured, and the lowest pressure is regarded as the rectangular pressure.

EP 3 904 417 A1

FIG. 1

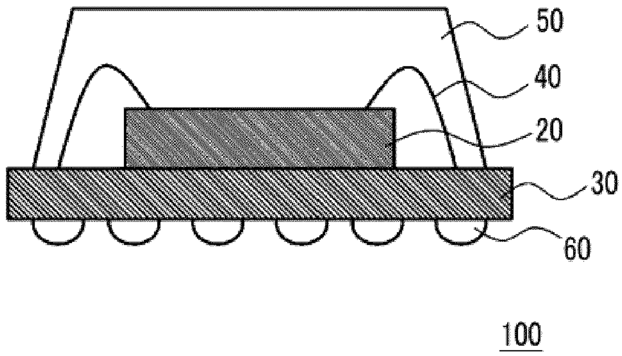

## Description

TECHNICAL FIELD

The present invention relates to a resin composition for sealing, a semiconductor device, and a method for producing a semiconductor device.

BACKGROUND ART

Various technologies have been developed as resin compositions for sealing semiconductor packages and the like. Furthermore, electronic components such as semiconductor packages are composed of members having various coefficients of linear expansion, and there is a problem that warpage occurs when electronic components are subjected to processes involving heating, such as post-curing and reflow, in the production process. Thus, for example, Patent Document 1 discloses a resin composition for sealing which contains an epoxy resin containing 30% to 100% by mass of a specific dihydroanthracene skeleton-containing epoxy resin, a phenol curing agent, an inorganic filler, and a stearate wax, and which has less warpage and a small change in warpage temperature over a range from room temperature to the reflow temperature.

RELATED DOCUMENT

PATENT DOCUMENT

[Patent Document 1] Japanese Unexamined Patent Publication No. 2010-084091

SUMMARY OF THE INVENTION

TECHNICAL PROBLEM

On the other hand, when sealing a semiconductor package or the like with a resin, there is a problem that a bonding wire connected to a semiconductor chip is deformed while the resin for sealing is flowing, and the deformation causes disconnection, contact, and the like.

According to an investigation conducted by the present inventors, it has been found that in a case where the resin composition for sealing described in Patent Document 1 is used, it is difficult to simultaneously suppress the wire flow at the time of sealing using the resin composition for sealing, and the warpage that occurs during post-curing or reflow of a semiconductor device sealed using resin composition for sealing. It is an object of the present invention to provide a resin composition for sealing with which wire flow occurs to a lesser extent at the time of resin sealing, and warpage occurs to a lesser extent during post-curing or the like of a semiconductor device sealed using the resin composition for sealing.

SOLUTION TO PROBLEM

According to the present invention, there is provided a resin composition for sealing containing:

(A) an epoxy resin;
(B) a curing agent; and
(C) a filler,

wherein the epoxy resin (A) includes an epoxy resin (A-1) having a naphthyl ether skeleton, and
wherein the resin composition for sealing satisfies the following Formula (1):

$$\text{Formula (1)} \quad E_2 \times (\alpha_2 \times 10^{-6}) \times (175 - Tg) \times \eta_2 \leq 0.3$$

wherein, in Formula (1), Tg (°C) is a glass transition temperature of a cured product of the resin composition for sealing,
$\alpha_2$ (ppm/°C) is a coefficient of linear expansion over a range from 190°C to 230°C of the cured product, and
$E_2$ (MPa) is a hot elastic modulus at 260°C of the cured product, and
$\eta_2$ (MPa) is a rectangular pressure at 175°C of the resin composition for sealing as measured by the following method;
(method)

the resin composition for sealing is injected, using a low-pressure transfer molding machine, into a rectangular-shaped flow channel having a width of 15 mm, a thickness of 1 mm, and a length of 175 mm under conditions of a mold temperature of 170°C and an injection flow rate of 177 $mm^3$/sec, a change in pressure over time is measured with a pressure sensor embedded at a position 25 mm away from an upstream tip of the flow channel, a lowest pressure (MPa) during a flow of the resin composition for sealing is measured, and the lowest pressure is regarded as the rectangular pressure.

Furthermore, according to the present invention, there is provided a semiconductor device having a seal resin formed by curing the resin composition for sealing.

Furthermore, according to the present invention, there is provided a method for producing a semiconductor device, the method including:

a step of mounting a semiconductor element on a substrate; and
a sealing step of sealing the semiconductor element using the above-described resin composition for sealing.

ADVANTAGEOUS EFFECTS OF INVENTION

According to the present invention, there are provided a resin composition for sealing with which wire flow occurs to a lesser extent at the time of resin sealing and warpage occurs to a lesser extent during post-curing of a semiconductor device sealed using the resin composition for sealing; a semiconductor device including a seal resin formed by curing the resin composition for sealing; and a method for producing the semiconductor device.

BRIEF DESCRIPTION OF THE DRAWINGS

The above-mentioned objectives and other objectives, features, and advantages will be further clarified by appropriate embodiments that will be described below and drawings associated therewith.

Fig. 1 is a cross-sectional view illustrating the configuration of a semiconductor device according to embodiments.
Fig. 2 is a cross-sectional view illustrating the configuration of a semiconductor device according to embodiments.

DESCRIPTION OF EMBODIMENTS

Hereinafter, embodiments of the present invention will be described in detail.

In the present specification, the notation "a to b" in the description of a numerical value range means equal to or more than a and equal to or less than b, unless specified otherwise. For example, the phrase "1% to 5% by mass" means "equal to or more than 1% by mass and equal to or less than 5% by mass".

The term "electronic device" in the present specification is meant to include an element, a device, a final manufactured product, and the like, to all of which electronic engineering technologies are applied, such as a semiconductor chip, a semiconductor element, a printed wiring board, an electric circuit display device, an information communication terminal, a light emitting diode, a physical battery, and a chemical battery.

In all the drawings, similar components will be assigned with similar reference numerals, and description thereof will not be repeated Moreover, the diagrams are schematic diagrams and do not match the actual dimensional ratios.

<Resin composition for sealing>

First, the resin composition for sealing according to the present embodiment will be described.

The resin composition for sealing of the present embodiment includes (A) an epoxy resin, (B) a curing agent, and (C) a filler.

Also, with regard to the resin composition for sealing according to the present embodiment, when the glass transition temperature of the cured product of the resin composition for sealing is denoted by Tg (°C),

a coefficient of linear expansion over a range from 190°C to 230°C by $\alpha_2$ (ppm/°C), and
a hot elastic modulus at 260°C by $E_2$ (MPa), and
when the rectangular pressure at 175°C of the resin composition for sealing as measured by the following method is denoted by $\eta_2$ (MPa), the following Formula (1) is satisfied:

$$\text{Formula (1)} \quad E_2 \times (\alpha_2 \times 10^{-6}) \times (175 - Tg) \times \eta_2 \leq 0.3$$

(method)
the resin composition for sealing is injected, using a low-pressure transfer molding machine, into a rectangular-shaped flow channel having a width of 15 mm, a thickness of 1 mm, and a length of 175 mm under conditions of a mold temperature of 170°C and an injection flow rate of 177 $mm^3$/sec, a change in pressure over time is measured with a pressure sensor embedded at a position 25 mm away from an upstream tip of the flow channel, a lowest pressure (MPa) during a flow of the resin composition for sealing is measured, and the lowest pressure is regarded as the rectangular pressure.

An electronic component such as a semiconductor package is composed of members having various coefficients of linear expansion, and when the electronic component is subjected to a process involving heating during the production process, since the various members have different amounts of shrinkage and different amounts of expansion, consequently warpage occurs. Since the occurrence of a large warpage leads to deterioration of reliability due to bonding defect or to difficulties in cutting during singulation of the package, suppression of warpage over a wide range from low temperatures to high temperatures has become an important issue. On the other hand, when sealing a semiconductor package or the like with a resin, there is a problem that the bonding wires connected to semiconductor chips are deformed during filling of the resin for sealing, and the deformation causes disconnection, contact, or the like. However, it has been difficult to achieve the suppression of wire flow and the suppression of warpage at the same time.

The present inventors have conducted a thorough investigation in order to achieve the suppression of wire flow and the suppression of warpage at the same time, and the inventors found that for a resin composition for sealing including (A) an epoxy resin, (B) a curing agent, and (C) a filler, when the resin composition for sealing is configured such that the glass transition temperature Tg, the coefficient of linear expansion $\alpha_2$, the hot elastic modulus $E_2$, and the rectangular pressure $\eta_2$ satisfy a specific relationship, that is, Formula (1), a resin composition for sealing that can achieve the above-described two problems at the same time is obtained, thus completing the present invention.

The reason why when a resin composition for sealing has the above-mentioned components and the resin composition for sealing satisfies the above-mentioned Formula (1), suppression of wire flow and suppression of warpage can be achieved at the same time, is not necessarily clearly understood; however, the following points can be inferred.

"$E_2 \times (\alpha_2 \times 10^{-6}) \times (175 - Tg)$" in the above-described Formula (1) is the product of the hot elastic modulus at a temperature equal to or higher than the glass transition temperature, the coefficient of linear expansion at a temperature equal to or higher than the glass transition temperature, and the difference between the curing temperature and the glass transition temperature, and represents the residual stress $S_2$ at high temperatures. The rectangular pressure $\eta_2$ represents the melt viscosity at high temperatures. According to the resin composition according to the present embodiment, it is speculated that as the product of the residual stress $S_2$ and the rectangular pressure $\eta_2$ representing the melt viscosity at high temperatures satisfies a specific condition, the internal stress accumulated at high temperatures and the fluidity at high temperatures can be optimally balanced, and both the suppression of wire flow during filling and the suppression of warpage of a cured product of the resin composition after being subjected to a thermal history can be achieved.

Furthermore, characteristics such as described above can be achieved by appropriately adjusting the types and the blending amounts of the various components constituting the resin composition for sealing of the present embodiment.

"$E_2 \times (\alpha_2 \times 10^{-6}) \times (175 - Tg) \times \eta_2$" represented by Formula (1) is equal to or less than 0.3, preferably equal to or less than 0.28, and particularly preferably equal to or less than 0.25. The lower limit of "$E_2 \times (\alpha_2 \times 10^{-6}) \times (175 - Tg) \times \eta_2$" is not particularly limited; however, the lower limit can be set to be, for example, equal to or more than 0.01.

The hot elastic modulus $E_2$ (MPa) can be measured by, for example, the following method according to JISK-6911. First, a resin composition for sealing is injection-molded using a low-pressure transfer molding machine ("KTS-15" manufactured by Kohtaki Corporation) at a mold temperature of 175°C, an injection pressure of 6.9 MPa, and a curing time of 120 seconds, and a specimen having a size of 10 mm × 4 mm × 4 mm is obtained. Next, this specimen was heated and measured over a measurement temperature range from 0°C to 300°C at a rate of 5°C/min by a three-point bending method using a DMA analyzer (manufactured by Seiko Instruments, Inc.), and the hot elastic modulus of the cured product at 260°C was measured. The unit of the hot elastic modulus $E_2$ is MPa.

The hot elastic modulus $E_2$ is not particularly limited as long as it satisfies the above-described Formula (1) in the relation with the other parameters; however, from the viewpoint of increasing the strength of the cured product, the hot elastic modulus $E_2$ is preferably equal to or more than 100 MPa, more preferably equal to or more than 500 MPa, and even more preferably equal to or more than 1000 MPa. Furthermore, from the viewpoint of realizing a cured product having excellent stress relaxation characteristics, the hot elastic modulus $E_2$ is preferably equal to or less than 10, 000 MPa, preferably equal to or less than 8000 MPa, and more preferably equal to or less than 6000 MPa.

The normal temperature elastic modulus $E_1$ at 25°C of a cured product of the resin composition for sealing, which is measured by DMA in the same manner as the hot elastic modulus $E_2$, is preferably equal to or more than 1000 MPa from the viewpoint of increasing the strength of the cured product, and the normal temperature elastic modulus $E_1$ is more preferably equal to or more than 3000 MPa, and even more preferably equal to or more than 5000 MPa.

Furthermore, from the viewpoint of realizing a cured product having excellent stress relaxation characteristics, the storage modulus $E_1$ at 25°C is preferably equal to or less than 40,000 MPa, more preferably equal to or less than 30,000 MPa, and even more preferably equal to or less than 25,000 MPa.

The glass transition temperature Tg (°C) and the coefficient of linear expansion $\alpha_2$ (ppm/°C) can be measured by, for example, the following methods. First, a resin composition for semiconductor sealing is injection-molded using a transfer molding machine at a mold temperature of 175°C, an injection pressure of 9.8 MPa, and a curing time of 3 minutes, and a specimen having a size of 15 mm × 4 mm × 4 mm is obtained. Next, the specimen thus obtained was post-cured at 175°C for 4 hours, and then measurement is performed using a thermomechanical analyzer (manufactured by Seiko Instruments & Electronics, Ltd., TMA100) under the conditions of a measurement temperature range of 0°C to 320°C and a rate of temperature increase of 5°C/min. From these measurement results, the glass transition temperature Tg (°C) and the coefficient of linear expansion ($\alpha_2$) at temperatures equal to or higher than the glass transition temperature are calculated. According to the present embodiment, the coefficient of linear expansion over a range from 190°C to 230°C is denoted by $\alpha_2$ (ppm/°C). Incidentally, the unit of the coefficient of linear expansion $\alpha_2$ is ppm/°C, and the unit of the glass transition temperature is °C.

The coefficient of linear expansion $\alpha_2$ is not particularly limited as long as it satisfies the above-described Formula (1) in the relationship with the other parameters; however, from the viewpoint of lowering the coefficient of linear expansion during a thermal history and suppressing the differences in the amount of expansion and the amount of shrinkage with the other materials constituting, for example, a semiconductor package, the coefficient of linear expansion $\alpha_2$ is preferably equal to or less than 75 ppm/°C, more preferably equal to or less than 70 ppm/°C, and even more preferably equal to or less than 65 ppm/°C. The lower limit value of the average coefficient of linear expansion $\alpha_2$ is not limited; however, the lower limit value may be, for example, equal to or more than 10 ppm/°C.

The glass transition temperature of the cured product is not limited as long as it satisfies the above-described Formula (1) is satisfied in the relation with the other parameters; however, the glass transition temperature is preferably equal to or higher than 100°C, more preferably equal to or higher than 110°C, even more preferably equal to or higher than 120°C, and particularly preferably higher than 125°C.

Furthermore, the upper limit of the glass transition temperature of the cured product is not limited; however, from the viewpoint of enhancing the toughness of the cured product, the upper limit is, for example, equal to or lower than 300°C, and more preferably lower than 175°C, and the upper limit may also be equal to or lower than 140°C.

From the viewpoint of suppressing the differences in the amount of expansion and the amount of shrinkage with the other materials constituting, for example, a semiconductor package, the coefficient of linear expansion $\alpha_1$ over a range from 40°C to 80°C of the cured product, which is determined by a method similar to the case of the coefficient of linear expansion $\alpha_2$, is preferably equal to or less than 50 ppm/°C, more preferably equal to or less than 45 ppm/°C, and even more preferably equal to or less than 40 ppm/°C. The lower limit value of the average coefficient of linear expansion $\alpha_1$ is not limited; however, the lower limit value may be, for example, equal to or more than 1 ppm/°C.

The rectangular pressure (injection pressure into a rectangular-shaped space) of the resin composition for semiconductor sealing of the present embodiment is not particularly limited as long as the rectangular pressure satisfies the above-described Formula (1) in the relationship with the other parameters; however, the upper limit value thereof is, for example, preferably equal to or less than 2.0 MPa, more preferably equal to or less than 1.0 MPa, even more preferably equal to or less than 0.3 MPa, and particularly preferably equal to or less than 0.2 MPa. As a result, the filling properties at the time of charging the resin composition for semiconductor sealing in between a substrate and a semiconductor element can be more effectively enhanced. The lower limit value of the rectangular pressure is preferably equal to or more than 0.03 MPa, more preferably equal to or more than 0.04 MPa, and particularly preferably equal to or more than 0.05 MPa. As a result, resin leakage from the mold gap during molding can be prevented.

The resin composition for sealing according to the present embodiment is such that when the glass transition temperature of a cured product of the resin composition for sealing is denoted by

Tg (°C),
the coefficient of linear expansion over a range from 40°C to 80°C as $\alpha_1$ (ppm/°C), and
the normal temperature elastic modulus at 25°C as $E_1$ (MPa),
the residual stress $S_1$ (MPa) represented by the following Formula (2) is preferably equal to or more than 10 MPa and equal to or less than 90 MPa, more preferably equal to or more than 20 MPa and equal to or less than 80 MPa, and particularly preferably equal to or more than 30 MPa and equal to or less than 70 MPa.

$$\text{Formula (2) Residual stress } S_1 = E_1 \times (\alpha_1 \times 10^{-6}) \times (Tg - (-40))$$

According to the present embodiment, the gelling time of the resin composition for sealing is preferably equal to or more than 10 seconds, and more preferably equal to or more than 20 seconds, from the viewpoint of accelerating the molding cycle while enhancing the moldability of the resin composition for sealing.

Furthermore, from the viewpoint of realizing a cured product having excellent curability, the gelling time of the resin composition for sealing is preferably equal to or less than 100 seconds, more preferably equal to or less than 80 seconds, and even more preferably equal to or less than 70 seconds.

Measurement of the gelling time can be carried out by melting the resin composition for sealing on a hot plate that has been heated to 175°C and then measuring the time taken to cure (gelling time) while kneading with a spatula.

According to the present embodiment, the spiral flow length of the resin composition for sealing is preferably equal to or more than 40 cm, from the viewpoint of more effectively enhancing the filling properties at the time of molding the resin composition for sealing, and the spiral flow length is more preferably 50 cm, and even more preferably 60 cm. Furthermore, the upper limit value of the spiral flow length is not limited; however, the upper limit value can be, for example, 200 cm.

With regard to the resin composition for semiconductor sealing of the present embodiment, the shrinkage rate $S_1$ when heat-treated at 175°C for 2 minutes can be adjusted to, for example, equal to or more than 0.05% and equal to or less than 2%, and a value equal to or more than 0.1% and equal to or less than 0.5% is more preferred. Furthermore, with regard to the resin composition for semiconductor sealing of the present embodiment, the shrinkage rate $S_2$ when heat-treated at 175°C for 4 hours can be adjusted to, for example, equal to or more than 0.05% and equal to or less than 2%, and a value equal to or more than 0.1% and equal to or less than 0.5% is more preferred. As such, by setting the shrinkage rate of the resin composition for semiconductor sealing during molding to a specific range, the amount of shrinkage of a substrate such as an organic substrate can be matched with the amount of shrinkage of the resin composition during curing, and the semiconductor package can be stabilized in a shape in which warpage is suppressed.

The resin composition for sealing according to the present embodiment includes (A) an epoxy resin, (B) a curing agent, and (C) a filler.

(Epoxy resin (A))

In the resin composition for sealing according to the present embodiment, the epoxy resin (A) includes an epoxy resin (A-1) having a naphthyl ether skeleton.

Since the resin composition for sealing according to the present embodiment includes an epoxy resin (A-1) having a naphthyl ether skeleton, has rigidity attributable to a structural unit containing the naphthalene skeleton, and does not have its crosslinking density excessively increased, it is presumed that a resin composition for sealing having an excellent balance between the viscosity characteristics during melting and the shrinkage rate as well as the elastic modulus obtainable when the resin composition forms a cured product, is obtained.

The resin composition for sealing according to the present embodiment may include at least one epoxy resin represented by the following General Formula (NE) as the epoxy resin (A-1) having a naphthyl ether skeleton.

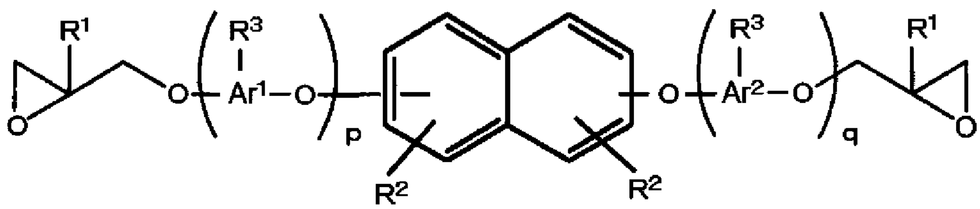 (NE)

In the above-described Formula (NE), $R^1$'s each independently represent a hydrogen atom or a methyl group; $Ar^1$ and $Ar^2$ each independently represent a naphthylene group or a phenylene group, while the two groups may each have an alkyl group having 1 to 4 carbon atoms or a phenylene group as a substituent. $R^2$'s each independently represent a hydrogen atom, an alkyl group having 1 to 4 carbon atoms, or an aralkyl group; p and q each independently represent an integer of 0 to 4, provided that either p or q is equal to or more than 1; and $R^3$'s each independently represent a hydrogen atom, an aralkyl group, or an epoxy group-containing aromatic hydrocarbon group.

In Formula (NE), in a case where $R^2$ represents an aralkyl group, the aralkyl group can be represented by the following Formula (A). Furthermore, in Formula (NE), in a case where $R^3$ is an aralkyl group, the aralkyl group can be represented by the following Formula (A) .

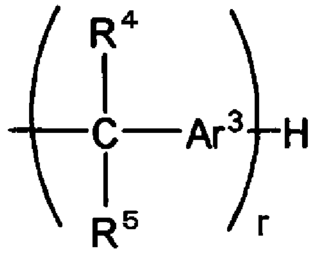

(A)

In Formula (A), $R^4$ and $R^5$ each independently represent a hydrogen atom or a methyl group; $Ar^3$ represents a phenylene group, a phenylene group or naphthylene group in which one to three hydrogen atoms have been nuclear-substituted by alkyl groups each having 1 to 4 carbon atoms, or a naphthylene group in which one to three hydrogen atoms have been nuclear-substituted by alkyl groups each having 1 to 4 carbon atoms. r represents a number of 0.1 to 4 on average.

In Formula (NE), in a case where $R^3$ represents an epoxy group-containing aromatic hydrocarbon group, the epoxy group-containing aromatic hydrocarbon group can be represented by the following Formula (E).

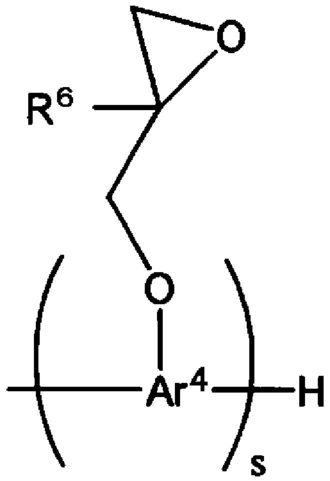

(E)

In Formula (E), $R^6$ represents a hydrogen atom or a methyl group; $Ar^4$ represents a naphthylene group or a naphthylene group having an alkyl group having 1 to 4 carbon atoms, an aralkyl group, or a phenylene group as a substituent; and s represents an integer of 1 or 2.

It is speculated that as the resin composition for sealing according to the present embodiment includes the epoxy resin (A-1) having a naphthyl ether skeleton of the above-described embodiment, a resin composition for sealing having an excellent balance between the viscosity characteristics during melting and the shrinkage rate as well as the elastic modulus obtainable when the resin composition forms a cured product, is obtained.

With regard to the resin composition for sealing according to the present embodiment, it is preferable that the epoxy resin (A) includes an epoxy resin (A-2) in addition to the above-mentioned epoxy resin (A-1) having a naphthyl ether skeleton.

The epoxy resin (A-2) includes one kind or two or more kinds selected from, for example, a biphenyl type epoxy resin; a bisphenol type epoxy resin such as a bisphenol A type epoxy resin, a bisphenol F type epoxy resin, or a tetramethyl bisphenol F type epoxy resin; a stilbene type epoxy resin; a novolac type epoxy resin such as a phenol novolac type epoxy resin or cresol novolac type epoxy resin; a polyfunctional epoxy resin such as a triphenolmethane type epoxy resin and an alkyl-modified triphenolmethane type epoxy resin; a phenol aralkyl type epoxy resin such as a phenol aralkyl type epoxy resin having a phenylene skeleton or a phenol aralkyl type epoxy resin having a biphenylene skeleton; a triazine nucleus-containing epoxy resin such as triglycidyl isocyanurate or monoallyl diglycidyl isocyanurate; and a bridged cyclic hydrocarbon compound-modified phenol type epoxy resin such as a dicyclopentadiene-modified phenol type epoxy resin.

Among these, from the viewpoint of enhancing the balance between moisture-resistant reliability and moldability, it is more preferable that the epoxy resin (A-2) includes at least one of a bisphenol type epoxy resin, a biphenyl type epoxy resin, a novolac type epoxy resin, a phenol aralkyl type epoxy resin, or a triphenolmethane type epoxy resin. From the viewpoint of suppressing warpage in a semiconductor device, it is particularly preferable that the epoxy resin

(A-2) includes at least one of a phenol aralkyl type epoxy resin or a novolac type epoxy resin. In order to further enhance fluidity, a biphenyl type epoxy resin is particularly preferred, and in order to control the elastic modulus at high temperatures, a phenol aralkyl type epoxy resin having a biphenylene skeleton is particularly preferred.

Regarding the epoxy resin (A-2), for example, an epoxy resin containing at least one selected from the group consisting of an epoxy resin represented by the following Formula (1), an epoxy resin represented by the following Formula (2), an epoxy resin represented by the following Formula (3), an epoxy resin represented by the following Formula (4), and an epoxy resin represented by the following Formula (5) can be used.

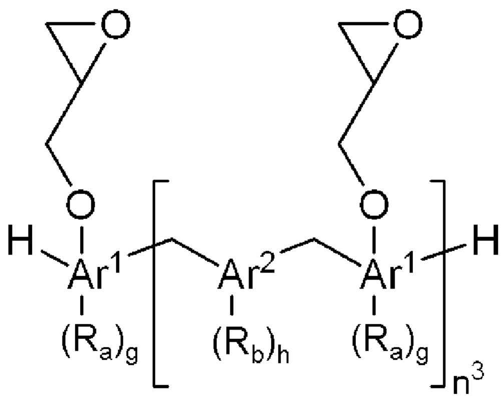

(1)

In the above-described Formula (1), $Ar^1$ represents a phenylene group or a naphthylene group, and in a case where $Ar^1$ is a naphthylene group, the glycidyl ether group may be bonded to either the $\alpha$-position or the $\beta$-position. $Ar^2$ represents any one group among a phenylene group, a biphenylene group, and a naphthylene group. $R_a$ and $R_b$ each independently represent a hydrocarbon group having 1 to 10 carbon atoms. g represents an integer of 0 to 5, and h represents an integer of 0 to 8. $n^3$ represents the degree of polymerization, and the average value thereof is 1 to 3.

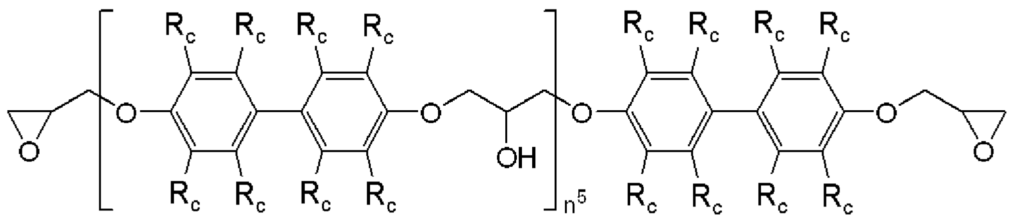

(2)

In Formula (2), a plurality of $R_c$'s each independently represent a hydrogen atom or a hydrocarbon group having 1 to 4 carbon atoms. $n^5$ represents the degree of polymerization, and the average value thereof is 0 to 4.

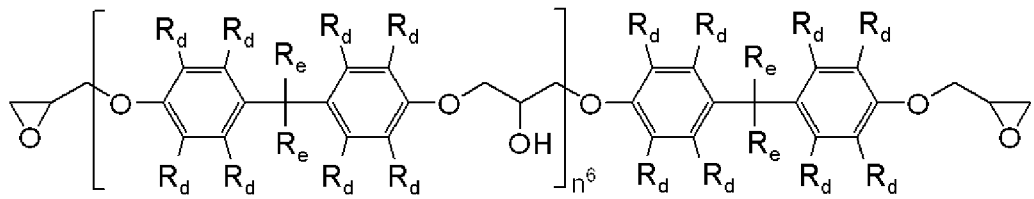

(3)

In Formula (3), a plurality of $R_d$'s and $R_e$'s each independently represent a hydrogen atom or a hydrocarbon group having 1 to 4 carbon atoms. $n^6$ represents the degree of polymerization, and the average value thereof is 0 to 4.

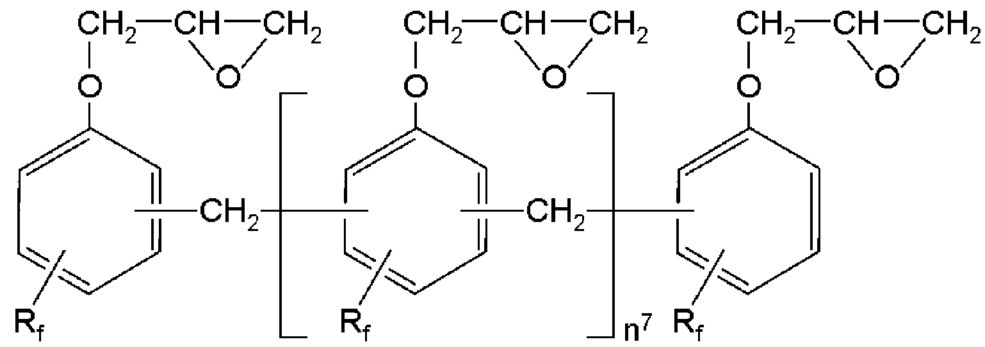

(4)

In Formula (4), a plurality of $R_f$'s each independently represent a hydrogen atom or a hydrocarbon group having 1 to 4 carbon atoms. $n^7$ represents the degree of polymerization, and the average value thereof is 0 to 4.

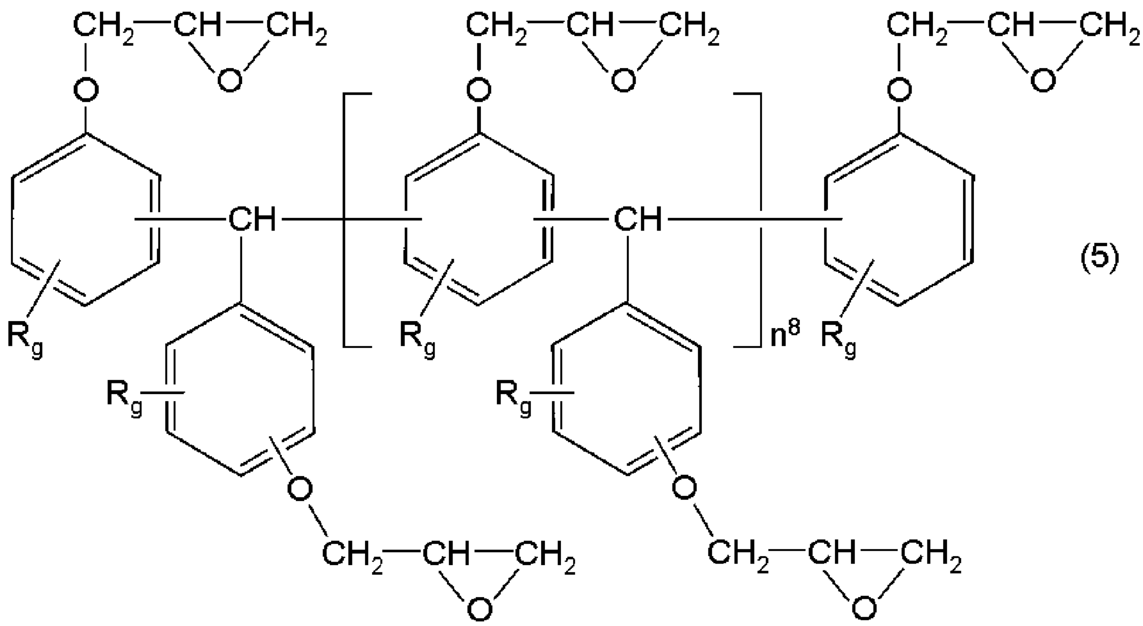

(5)

In Formula (5), a plurality of $R_g$' s each independently represent a hydrogen atom or a hydrocarbon group having 1 to 4 carbon atoms. $n^8$ represents the degree of polymerization, and the average value thereof is 0 to 4.

Among those described above, it is one of more preferred embodiments to include an epoxy resin represented by the above-described Formula (5) as the epoxy resin (A-2).

According to the present embodiment, when the total amount of the epoxy resin (A) including the epoxy resin (A-1) having a naphthyl ether skeleton is designated as 100 parts by mass, or when the total amount of the epoxy resin (A) combining the epoxy resin (A-1) having a naphthyl ether skeleton and the epoxy resin (A-2) other than the epoxy resin (A-1) is designated as 100 parts by mass, the content of the epoxy resin (A-1) is preferably equal to or more than 1 part by mass and equal to or less than 70 parts by mass, more preferably equal to or more than 10 parts by mass and equal to or less than 65 parts by mass, and particularly preferably equal to or more than 30 parts by mass and equal to or less than 60 parts by mass.

(Curing agent (B))

The curing agent (B) according to the present embodiment is not particularly limited as long as it is an agent that is generally used for resin compositions for semiconductor sealing; however, examples include a phenolic curing agent, an amine-based curing agent, an acid anhydride-based curing agent, and a mercaptan-based curing agent, and at least one selected from these can be included. Among these, it is preferable that the curing agent includes a phenolic curing agent from the viewpoint of balance between flame resistance, moisture resistance, electrical characteristics, curability, storage stability, and the like.

<Phenolic curing agent>

The phenolic curing agent is not particularly limited as long as it is an agent that is generally used for resin compositions for semiconductor sealing; however, examples include novolac resins obtainable by condensing or co-condensing phenols such as phenol, cresol, resorcin, catechol, bisphenol A, bisphenol F, phenylphenol, aminophenol, α-naphthol, β-naphthol, and dihydroxynaphthalene, with formaldehyde or ketones in the presence of an acidic catalyst, such as a phenol novolac resin and a cresol novolac resin; phenol aralkyl resins such as a phenol aralkyl resin having a biphenylene skeleton synthesized from the above-described phenols and dimethoxyparaxylene or bis(methoxymethyl)biphenyl, and a phenol aralkyl resin having a phenylene skeleton; and phenolic resins having a trisphenylmethane skeleton, and these may be used singly or in combination of two or more kinds thereof.

<Amine-based curing agent>

Examples of the amine-based curing agent include aliphatic polyamines such as diethylenetriamine (DETA), triethylenetetramine (TETA), and meta-xylylenediamine (MXDA); aromatic polyamines such as diaminodiphenylmethane (DDM), m-phenylenediamine (MPDA), and diaminodiphenylsulfone (DDS); and polyamine compounds containing dicyandiamide (DICY) and organic acid dihydrazides, and these may be used singly or in combination of two or more kinds thereof.

<Acid anhydride-based curing agent>

Examples of the acid anhydride-based curing agent include alicyclic acid anhydrides such as hexahydrophthalic anhydride (HHPA), methyltetrahydrophthalic anhydride (MTHPA), and maleic anhydride; and aromatic acid anhydrides such as trimellitic anhydride (TMA), pyromellitic anhydride (PMDA), benzophenone tetracarboxylic acid (BTDA), and phthalic anhydride, and these may be used singly or in combination of two or more kinds thereof.

<Mercaptan-based curing agent>

Examples of the mercaptan-based curing agent include trimethylolpropane tris(3-mercaptobutyrate) and trimethylolethane tris(3-mercaptobutyrate), and these may be used singly or in combination of two or more kinds thereof.

<Other curing agents>

Examples of other curing agents include isocyanate compounds such as an isocyanate prepolymer and a blocked isocyanate; and organic acids such as carboxylic acid-containing polyester resins, and these may be used singly or in combination of two or more kinds thereof.

Furthermore, two or more kinds of different systems of curing agents among those described above may be used in combination.

The resin composition for sealing may include only one kind of the curing agent (B) or may include two or more kinds thereof.

According to the present embodiment, regarding the curing agent (B), it is preferable that 30 to 70 parts by mass is included, more preferably 35 to 65 parts by mass is included, and particularly preferably 40 to 60 parts by mass is included, with respect to 100 parts by mass of the epoxy resin (A).

The content of the curing agent (B) is, for example, preferably equal to or more than 0.5% by mass, more preferably equal to or more than 1% by mass, and even more preferably equal to or more than 1.5% by mass, with respect to 100% by mass of the total solid content of the resin composition for sealing. As a result, excellent fluidity is obtained during molding, and enhancement of the filling properties and moldability can be promoted.

The upper limit value of the content of the curing agent (B) is not particularly limited; however, for example, the upper limit value is preferably equal to or less than 9% by mass, more preferably equal to or less than 8% by mass, and even more preferably equal to or less than 7% by mass, with respect to 100% by mass of the total solid content of the resin composition for sealing.

As a result, the moisture-resistant reliability and reflow resistance of the electronic device can be enhanced. In addition, the resin composition for sealing can contribute to further suppression of warpage of the base material.

(Filler (C))

The resin composition for sealing of the present embodiment includes a filler (C).

Specific examples of the filler (C) include inorganic fillers such as silica, alumina, titanium white, aluminum hydroxide, talc, clay, mica, and glass fibers.

It is preferable that the filler (C) includes silica. Examples of silica include fused crushed silica, fused spherical

silica, crystalline silica, and secondary aggregated silica. Among these, fused spherical silica is particularly preferred.

The filler (C) is usually particles. It is preferable that the shape of the particles is substantially spherical.

The average particle size of the filler (C) is not particularly limited; however, the average particle size is typically 1 to 100 μm, preferably 1 to 50 μm, and more preferably 1 to 20 μm. As the average particle size is appropriate, appropriate fluidity can be secured during curing, or the like. It is also conceivable to improve, for example, the filling properties into a narrow gap portion in the state-of-the-art wafer level package by making the average particle size relatively small (for example, 1 to 20 μm).

The average particle size of the filler (C) can be determined by acquiring the data of a volume-based particle size distribution using a laser diffraction and scattering type particle size distribution analyzer (for example, a wet particle size distribution measuring machine LA-950 manufactured by Horiba, Ltd.) and processing the data. Measurement is usually carried out in a wet mode.

The filler (C) such as silica may have the surface-modified with a coupling agent such as a silane coupling agent. As a result, agglomeration of the filler (C) is suppressed, and more satisfactory fluidity can be obtained. In addition, the affinity of the filler (C) for other components is improved, and dispersibility of the filler (C) is enhanced. It is considered that this contributes to an enhancement of mechanical strength of the cured product, suppression of the occurrence of microcracks, and the like.

As a coupling agent for surface modification, those listed as examples of the coupling agent (E) that will be described later can be used.

The resin composition for sealing may include only one kind of filler (C) or may include two or more kinds of fillers (C).

The content of the filler (C) is not particularly limited; however, for example, it is preferable that the content thereof is equal to or more than 65% by mass and equal to or less than 98% by mass, more preferably equal to or more than 68% by mass and equal to or less than 95% by mass, and particularly preferably equal to or more than 70% by mass and equal to or less than 93% by mass, with respect to 100% by mass of the total solid content of the resin composition for sealing. By making the content of the filler (C) appropriately large, low hygroscopic properties and the like can be enhanced, and the moisture-resistant reliability and reflow resistance of the electronic device can be more effectively enhanced. Particularly, when the content of the filler (C) is made appropriately large and the content of resin components (epoxy resin (A), curing agent (B), and the like) is relatively reduced, theoretically curing shrinkage occurs to a lesser extent, and therefore, warpage can be further reduced. By appropriately reducing the content of the filler (C), it is possible to suppress a decrease in moldability caused by a decrease in fluidity during molding. According to the resin composition of the present embodiment, even if the content of the filler (C) is made appropriately large, it is possible to suppress a decrease in fluidity during molding, and the like.

(Curing accelerator)

The resin composition for sealing of the present embodiment may include a curing accelerator. The curing accelerator may be any one that accelerates the curing of a thermosetting resin and is selected according to the type of the thermosetting resin.

According to the present embodiment, the curing accelerator includes one kind or two or more kinds selected from the group consisting of phosphorus atom-containing compounds such as an organic phosphine, a tetra-substituted phosphonium compound, a phosphobetaine compound, an adduct of a phosphine compound and a quinone compound, and an adduct of a phosphonium compound and a silane compound; imidazole compounds such as 2-methylimidazole, 2-ethyl-4-methylimidazole (EMI24), 2-phenyl-4-methylimidazole (2P4MZ), 2-phenylimidazole (2PZ), 2-phenyl-4-methyl-5-hydroxyimidazole (2P4MHZ), and 1-benzyl-2-phenylimidazole (1B2PZ); and nitrogen atom-containing compounds such as amidines, which are exemplified by 1,8-diazabicyclo[5.4.0]undecene-7 and benzyldimethylamine, tertiary amines, and quaternary salts of the above-described amidines and amines. From the viewpoint of enhancing the curability of the resin composition for sealing and from the viewpoint of enhancing the close adhesiveness between the seal material and a metal, the curing accelerator preferably includes an imidazole compound.

The content of the curing accelerator in the resin composition for sealing is preferably equal to or more than 0.01% by mass, more preferably equal to or more than 0.03% by mass, and even more preferably equal to or more than 0.05% by mass, with respect to the total amount of the resin composition for sealing, from the viewpoint of effectively enhancing the curability of the resin composition.

Furthermore, from the viewpoint of enhancing the handling of the resin composition for sealing, the content of the curing accelerator in the resin composition for sealing is preferably equal to or less than 5% by mass, more preferably equal to or less than 3% by mass, and even more preferably equal to or less than 1% by mass, with respect to the total amount of the resin composition for sealing.

(Coupling agent)

The resin composition for sealing of the present embodiment may include a coupling agent. When the resin composition for sealing includes a coupling agent, for example, a further enhancement of the close adhesiveness to a base material and an enhancement of the dispersibility of the filler in the composition can be promoted. When the dispersibility of the filler is enhanced, the homogeneity of the finally obtained cured product is enhanced. This can contribute to an increase in the mechanical strength of the cured product, and the like.
Regarding the coupling agent, for example, known coupling agents such as various silane-based compounds such as epoxysilane, mercaptosilane, aminosilane, alkylsilane, ureidosilane, vinylsilane, and methacrylsilane; titanium-based compounds, aluminum chelates, and aluminum- and zirconium-based compounds, can be used.
More specifically, the following can be mentioned as examples.

Silane-based coupling agents

Vinyltrichlorosilane, vinyltrimethoxysilane, vinyltriethoxysilane, vinyltris(β-methoxyethoxy)silane,

γ-methacryloxypropyltrimethoxysilane,
β-(3,4-epoxycyclohexyl)ethyltrimethoxysilane,
γ-glycidoxypropyltrimethoxysilane,
γ-glycidoxypropyltriethoxysilane,
γ-glycidoxypropylmethyldimethoxysilane,
γ-methacryloxypropylmethyldiethoxysilane,
γ-methacryloxypropyltriethoxysilane, vinyltriacetoxysilane,
γ-mercaptopropyltrimethoxysilane, γ-aminopropyltriethoxysilane,
γ-anilinopropyltrimethoxysilane,
γ-anilinopropylmethyldimethoxysilane,
γ-[bis(β-hydroxyethyl)]aminopropyltriethoxysilane,
N-β-(aminoethyl)-γ-aminopropyltrimethoxysilane,
N-β-(aminoethyl)-γ-aminopropyltriethoxysilane,
N-β-(aminoethyl)-γ-aminopropylmethyldimethoxysilane,
phenylaminopropyltrimethoxysilane,
γ-(β-aminoethyl)aminopropyldimethoxymethylsilane,
N-(trimethoxysilylpropyl)ethylenediamine,
N-(dimethoxymethylsilylisopropyl)ethylenediamine,
methyltrimethoxysilane, dimethyldimethoxysilane,
methyltriethoxysilane,
N-β-(N-vinylbenzylaminoethyl)-γ-aminopropyltrimethoxysilane,
γ-chloropropyltrimethoxysilane, hexamethyldisilane,
vinyltrimethoxysilane, γ-mercaptopropylmethyldimethoxysilane,
3-isocyanatopropyltriethoxysilane,
3-acryloxypropyltrimethoxysilane, hydrolysate of 3-triethoxysilyl-N-(1,3-dimethyl-butylidene)propylamine, and the like.

Titanate-based coupling agents

Isopropyl triisostearoyl titanate, isopropyl tris(dioctyl pyrophosphate) titanate, isopropyl tri(N-aminoethyl-aminoethyl) titanate, tetraoctyl bis(ditridecyl phosphite) titanate, tetra(2,2-diallyloxymethyl-1-butyl) bis(ditridecyl) phosphite titanate, bis(dioctyl pyrophosphate) oxyacetate titanate, bis (dioctyl pyrophosphate) ethylene titanate, isopropyl trioctanoyl titanate, isopropyl dimethacrylisostearoyl titanate, isopropyl tridodecylbenzenesulfonyl titanate, isopropyl isostearoyl diacryl titanate, isopropyl tri(dioctyl phosphate) titanate, isopropyl tricumylphenyl titanate, tetraisopropyl bis(dioctyl phosphate) titanate, and the like.
In a case where the resin composition for sealing includes a coupling agent, only one kind of coupling agent may be included, or two or more kinds of coupling agents may be included.
There is no particular lower limit on the content of the coupling agent; however, for example, the content is preferably equal to or more than 0.05% by mass, and more preferably equal to or more than 0.1% by mass, with respect to the total amount of the resin composition for sealing. By setting the content of the coupling agent to be equal to or more than these lower limit values, the effect of adding the coupling agent is sufficiently easily obtained.
There is no particular upper limit on the content of the coupling agent; however, the content is preferably equal

to or less than 2.0% by mass, and more preferably equal to or less than 1.0% by mass, with respect to the total amount of the resin composition for sealing. By setting the content of the coupling agent to be equal to or less than these upper limit values, appropriate fluidity of the resin composition for sealing is obtained during sealing-molding, and satisfactory filling properties and moldability are obtained.

(Other components)

The resin composition for sealing of the present embodiment may further include, if necessary, various additives such as a pH adjuster, an ion scavenger, a flame retardant, a colorant, a mold release agent, a low stress agent, an oxidation inhibitor, and a heavy metal inactivating agent.

As the pH adjuster, for example, hydrotalcite can be used. It is said that hydrotalcite maintains the pH in the composition near neutrality, and consequently, ions such as $Cl^-$ are not likely to be generated.

As the ion scavenger (also referred to as ion catcher, ion trapping agent, or the like), for example, bismuth oxide, yttrium oxide, or the like can be used.

In a case where a pH adjuster and/or an ion scavenger is used, only one kind thereof may be used, or two or more kinds thereof may be used in combination.

In a case where a pH adjuster and/or an ion scavenger is used, the amount thereof is, for example, 0.05% to 0.3% by mass, and preferably 0.1% to 0.2% by mass, with respect to the total amount of the resin composition for sealing.

Examples of a flame retardant include inorganic flame retardants (for example, hydrated metal-based compounds such as aluminum hydroxide, available from Sumitomo Chemical Co., Ltd.), halogen-based flame retardants, phosphorus-based flame retardants, and organic metal salt-based flame retardants.

In a case where a flame retardant is used, only one kind thereof may be used, or two or more kinds thereof may be used in combination.

In a case where a flame retardant is used, the content is not particularly limited; however, the content is, for example, equal to or less than 10% by mass, and preferably equal to or less than 5% by mass, with respect to the total amount of the resin composition for sealing. By setting the content to be equal to or less than these upper limit values, the electrical reliability of the package can be maintained.

Specific examples of the colorant include carbon black, red iron oxide, and titanium oxide.

In a case where a colorant is used, one kind or a combination of two or more kinds can be used.

In a case where a colorant is used, the amount thereof is, for example, 0.1% to 0.5% by mass, and preferably 0.2% to 0.4% by mass, with respect to the total amount of the resin composition for sealing.

Examples of the mold release agent include natural waxes; synthetic waxes such as a montanic acid ester; higher fatty acids or metal salts thereof, paraffin, and polyethylene oxide.

In a case where a mold release agent is used, only one kind thereof may be used, or two or more kinds thereof may be used in combination.

In a case where a mold release agent is used, the amount thereof is, for example, 0.1% to 0.5% by mass, and preferably 0.2% to 0.3% by mass, with respect to the total amount of the resin composition for sealing.

Examples of the low stress agent include silicone oil, silicone rubber, polyisoprene, polybutadiene such as 1,2-polybutadiene or 1,4-polybutadiene, styrene-butadiene rubber, acrylonitrile-butadiene rubber, polychloroprene, poly(oxypropylene), poly(oxytetramethylene) glycol, polyolefin glycol, thermoplastic elastomers such as poly-ε-caprolactone, polysulfide rubber, and fluororubber.

In a case where a low stress agent is used, only one kind thereof may be used, or two or more kinds thereof may be used in combination.

In a case where a low stress agent is used, the amount thereof can be set to, for example, 0.05% to 1.0% by mass with respect to the total amount of the resin composition for sealing.

Next, a method for producing the resin composition for sealing will be described.

The resin composition for sealing of the present embodiment can be obtained by, for example, mixing the above-mentioned various components by a known means, further melt-kneading the mixture with a kneader such as a roll, a kneader, or an extruder, cooling the mixture, and then pulverizing the resulting product. Furthermore, products obtained by tablet-molding these into a tablet form can also be used as a resin composition for sealing. As a result, a resin composition for sealing in a granular form or a tablet form can be obtained.

By producing such a tablet-molded composition, performing sealing-molding using known molding methods such as transfer molding, injection-molding, and compression molding is facilitated.

The resin composition for sealing of the present embodiment can be used for various use applications such as a resin composition for sealing a semiconductor element such as a general semiconductor element or a power semiconductor, a resin composition for sealing a wafer, a resin composition for forming a pseudo-wafer, a resin composition for sealing for forming an in-vehicle electronic control unit, a resin composition for sealing for forming a wiring substrate, and a resin composition for sealing for a rotor fixing member.

Hereinafter, the semiconductor device will be described.

<Semiconductor device>

The semiconductor device according to the present embodiment is a semiconductor device including a seal resin formed by curing the resin composition for sealing according to the present embodiment.
Fig. 1 is a cross-sectional view illustrating the configuration of a semiconductor device 100 according to the present embodiment. The semiconductor device 100 shown in Fig. 1 includes a semiconductor element 20 mounted on a substrate 30, and a seal material 50 formed by sealing the semiconductor element 20.
The seal material 50 is composed of a cured product obtained by curing the resin composition for sealing of the present embodiment.
Furthermore, Fig. 1 illustrates a case where the substrate 30 is a circuit board. In this case, as shown in Fig. 1, on the other surface of the substrate 30, which is on the opposite side of the surface on which the semiconductor element 20 is mounted, for example, a plurality of solder balls 60 are formed. The semiconductor element 20 is mounted on the substrate 30 and is electrically connected to the substrate 30 through a wire 40. On the other hand, the semiconductor element 20 may be flip-chip mounted on the substrate 30. Here, the wire 40 is formed of, for example, copper.
The seal material 50 seals the semiconductor element 20 so as to cover the other surface of the semiconductor element 20, which is on the opposite side of the surface facing the substrate 30. In the example shown in Fig. 1, the seal material 50 is formed so as to cover the above-described other surface and lateral faces of the semiconductor element 20. The seal material 50 can be formed, for example, by sealing-molding a resin composition for sealing using a known method such as a transfer molding method or a compression molding method.
As a method of producing the semiconductor device 100, for example,

a production method including a step of mounting a semiconductor element 20 on a substrate 30; and
a sealing step of sealing the semiconductor element using the resin composition for sealing according to the present embodiment,
may be mentioned.

Furthermore, as a production method for obtaining a semiconductor device in which the semiconductor device 100 is further electrically joined to another substrate, a method for producing a semiconductor device having a reflow step after the sealing step may be mentioned. In the production method according to the present embodiment, the reflow temperature in the reflow step can be adjusted to be, for example, equal to or higher than 200°C and can also be adjusted to be equal to or higher than 230°C, and particularly, it is also possible to adjust the reflow temperature to be equal to or higher than 260°C. According to the present embodiment, since a seal material 50 is formed using the resin composition for sealing according to the present embodiment as described above, the occurrence of warpage can be suppressed even after being subjected to such a high-temperature reflow. Therefore, it is possible to enhance the reliability of the semiconductor device 100.
Fig. 2 is a cross-sectional view illustrating the configuration of the semiconductor device 100 according to the present embodiment and shows an example different from that of Fig. 1. The semiconductor device 100 shown in Fig. 2 uses a lead frame as a substrate 30. In this case, the semiconductor element 20 is mounted on, for example, a die pad 32 in the substrate 30 and is electrically connected to an outer lead 34 through a wire 40. Furthermore, the seal material 50 is formed using the resin composition for sealing according to the present embodiment in the same manner as in the example shown in Fig. 1.
It should be noted that the present invention is not intended to be limited to the above-described embodiments, and modifications, improvements, and the like made to the extent that the object of the present invention can be achieved are included in the present invention.

[Examples]

Hereinafter, the present invention will be described in detail with reference to Examples; however, the present invention is not intended to be limited to the description of these Examples.

<Examples 1 to 9 and Comparative Example 1 (production of resin composition for sealing)>

First, various components in the blending amounts (part by mass) described in Table 1 were mixed at normal temperature using a mixer to obtain a mixture.
Next, the mixture was heated and kneaded at a temperature of equal to or higher than 70°C and equal to or lower than 100°C.

Then, the mixture was cooled to normal temperature and then pulverized to obtain a resin composition for sealing.

The details of the various raw material components described in Table 1 are as follows.

(Epoxy resin)

- Epoxy resin 1: Epoxy resin including an epoxy resin having a naphthyl ether skeleton represented by the above-described Formula (NE) as a main component (manufactured by DIC Corporation, product number: HP6000L).
- Epoxy resin 2: Biphenylene skeleton-containing phenol aralkyl type epoxy resin (manufactured by Nippon Kayaku Co., Ltd., product number: NC3000)
- Epoxy resin 3: Epoxy resin including an epoxy resin having a triphenylmethane skeleton represented by the above-described Formula (5) as a main component (manufactured by JER Co., Ltd., product number: YL6677).
- Epoxy resin 4: Biphenyl type epoxy resin represented by the above-described Formula (2) (manufactured by Mitsubishi Chemical Corporation, product number: YX-4000K)
- Epoxy resin 5: Dicyclopentadiene type epoxy resin (manufactured by DIC Corporation, product number: HP-7200L)

(Curing agent)

- Curing agent 1: Biphenylene skeleton-containing phenol aralkyl type resin (manufactured by Nippon Kayaku Co., Ltd., product number: GPH-65)
- Curing agent 2: Trisphenylmethane type phenolic resin (Air Water, Inc., HE910-20)
- Curing agent 3: Biphenyl aralkyl type phenolic resin (manufactured by Meiwa Plastic Industries, Ltd., product number: MEH-7851H)
- Curing agent 4: Biphenyldimethylene type phenolic resin (manufactured by Meiwa Plastic Industries, Ltd., product number: MEH-7851SS)
- Curing agent 5: Biphenyl aralkyl type phenolic resin (manufactured by Meiwa Plastic Industries, Ltd., product number: SH-002-02)

(Inorganic filler)

- Inorganic filler 1: Fused spherical silica (manufactured by Tokai Minerals Co., Ltd., ES series)
- Inorganic filler 2: Fused spherical silica (manufactured by Micron Technology, Inc., TS series)
- Inorganic filler 3: Fused spherical silica having an average particle size of 0.6 $\mu$m, a specific surface area of 6.4 $m^2$/g, and an upper limit cutoff of 45 $\mu$m (manufactured by Admatechs Co., Ltd., product number: SC-2500-SQ).
- Inorganic filler 4: Fused spherical silica having an average particle size of 1.6 $\mu$m, a specific surface area of 4.4 $m^2$/g, and an upper limit cutoff of 45 $\mu$m (manufactured by Admatechs Co., Ltd., product number: SC-5500-SQ).
- Inorganic filler 5: Fused spherical silica (manufactured by Admatechs Co., Ltd., product number: FEB24S5)
- Inorganic filler 6: Fused spherical silica (manufactured by Admatechs Co., Ltd., product number: SD2500-SQ)
- Inorganic filler 7: Fused spherical silica (manufactured by Admatechs Co., Ltd., product number: SD5500-SQ)
- Inorganic filler 8: Fused spherical silica (manufactured by Denka Co., Ltd., product number: FB-950)
- Inorganic filler 9: Fused spherical silica (manufactured by Denka Co., Ltd., product number: FB-105)

(Curing accelerator)

- Curing accelerator 1: Tetraphenylphosphonium-4,4'-sulfonyl diphenolate (manufactured by Sumitomo Bakelite Co., Ltd.)
- Curing accelerator 2: Tetraphenylphosphonium bis(naphthalene-2,3-dioxy)phenyl silicate (manufactured by Sumitomo Bakelite Co., Ltd.)

(Coupling agent)

· Coupling agent 1: N-phenyl-3-aminopropyltrimethoxysilane (Dow Corning Toray Co., Ltd., CF4083)

(Ion scavenger)

· Ion scavenger 1: Magnesium aluminum hydroxide carbonate hydrate (manufactured by Kyowa Chemical Industry Co., Ltd., product number: DHT-4H)

(Mold release agent)

- · Mold release agent 1: Polyethylene oxide wax (manufactured by Clariant Japan K.K., product number: LICOWAX PED191)
- · Mold release agent 2: Carnauba wax (manufactured by Toa Kasei Co., Ltd., product number: TOWAX-132)

(Colorant)

· Colorant 1: Carbon black (Mitsubishi Chemical Corporation, CARBON #5)

(Low stress agent)

- · Low stress agent 1: Carboxyl group-terminated butadiene-acrylonitrile copolymer (manufactured by Ube Industries, Ltd., product number: CTBN1008SP)
- · Low stress agent 2: Dimethylsiloxane-alkylcarboxylic acid-4,4'-(1-methylethylidene)bisphenol diglycidyl ether copolymer (melt reaction product A described in paragraph 0068 of Japanese Patent No. 5157473).
- · Low stress agent 3: Silicone resin (manufactured by Shin-Etsu Chemical Co., Ltd., KR-480)

(Flame retardant)

· Flame retardant 1: Aluminum hydroxide (manufactured by Sumitomo Chemical Co., Ltd., trade name CL303)

[Table 1]

| (parts by mass) | | Example 1 | Example 2 | Example 3 | Example 4 | Example 5 | Example 6 | Example 7 | Example 8 | Example 9 | Comparative Example 1 |
|---|---|---|---|---|---|---|---|---|---|---|---|
| Epoxy resin | Epoxy resin 1 | 3.73 | 4.05 | 4.35 | 4.66 | 3.42 | 3.12 | 2.81 | 16.64 | 2.04 | - |
| | Epoxy resin 2 | | | | | | | | | | 3.87 |
| | Epoxy resin 3 | 3.73 | 4.04 | 4.34 | 4.66 | 3.43 | 3.11 | 2.81 | | | 3.87 |
| | Epoxy resin 4 | | | | | | | | | 1.02 | |
| | Epoxy resin 5 | | | | | | | | | 2.04 | |
| Curing agent | Curing agent 1 | 2.12 | 2.29 | 2.47 | 2.64 | 1.94 | 1.77 | 1.59 | 1.10 | | 1.98 |
| | Curing agent 2 | 2.12 | 2.29 | 2.47 | 2.64 | 1.94 | 1.77 | 1.59 | | | 1.98 |
| | Curing agent 3 | | | | | | | | 10.80 | | |
| | Curing agent 4 | | | | | | | | | 2.54 | |
| | Curing agent 5 | | | | | | | | | 0.84 | |
| Inorganic filler | Inorganic filler 1 | 43.85 | 42.85 | 41.85 | 40.85 | 44.85 | 45.85 | 46.85 | | | 43.85 |
| | Inorganic filler 2 | 30.00 | 30.00 | 30.00 | 30.00 | 30.00 | 30.00 | 30.00 | | | 30.00 |
| | Inorganic filler 3 | 5.00 | 5.00 | 5.00 | 5.00 | 5.00 | 5.00 | 5.00 | | 15.00 | 5.00 |
| | Inorganic filler 4 | 5.00 | 5.00 | 5.00 | 5.00 | 5.00 | 5.00 | 5.00 | | | 5.00 |
| | Inorganic filler 5 | | | | | | | | 29.90 | | |
| | Inorganic filler 6 | | | | | | | | 15.00 | | |
| | Inorganic filler 7 | | | | | | | | 15.00 | | |
| | Inorganic filler 8 | | | | | | | | | 51.85 | |
| | Inorganic filler 9 | | | | | | | | | 20.00 | |
| Curing accelerator | Curing accelerator 1 | 0.15 | 0.16 | 0.18 | 0.19 | 0.14 | 0.13 | 0.11 | 0.05 | 0.20 | 0.15 |
| | Curing accelerator 2 | 0.25 | 0.27 | 0.29 | 0.31 | 0.23 | 0.21 | 0.19 | 0.51 | | 0.25 |
| Coupling agent | Coupling agent 1 | 0.20 | 0.20 | 0.20 | 0.20 | 0.20 | 0.20 | 0.20 | 0.20 | 0.30 | 0.20 |

(continued)

| (parts by mass) | | Example 1 | Example 2 | Example 3 | Example 4 | Example 5 | Example 6 | Example 7 | Example 8 | Example 9 | Comparative Example 1 |
|---|---|---|---|---|---|---|---|---|---|---|---|
| Ion scavenger | Ion scavenger 1 | 0.15 | 0.15 | 0.15 | 0.15 | 0.15 | 0.15 | 0.15 | 0.15 | 0.15 | 0.15 |
| Mold release agent | Mold release agent 1 | 0.15 | 0.15 | 0.15 | 0.15 | 0.15 | 0.15 | 0.15 | 0.20 | 0.20 | 0.15 |
| | Mold release agent 2 | 0.10 | 0.10 | 0.10 | 0.10 | 0.10 | 0.10 | 0.10 | | | 0.10 |
| Colorant | Colorant 1 | 0.30 | 0.30 | 0.30 | 0.30 | 0.30 | 0.30 | 0.30 | 0.30 | 0.30 | 0.30 |
| Low stress agent | Low stress agent 1 | 0.05 | 0.05 | 0.05 | 0.05 | 0.05 | 0.05 | 0.05 | 0.05 | 0.40 | 0.05 |
| | Low stress agent 2 | 0.10 | 0.10 | 0.10 | 0.10 | 0.10 | 0.10 | 0.10 | 0.10 | 0.12 | 0.10 |
| | Low stress agent 3 | | | | | | | | | 3.00 | |
| Flame retardant | Flame retardant 1 | 3.00 | 3.00 | 3.00 | 3.00 | 3.00 | 3.00 | 3.00 | 10.00 | | 3.00 |
| | Total | 100.00 | 100.00 | 100.00 | 100.00 | 100.00 | 100.00 | 100.00 | 100.00 | 100.00 | 100.00 |

[Evaluation items]

(Fluidity (spiral flow))

A resin composition for semiconductor sealing obtained as described above was injected into a mold for measuring spiral flow according to ANSI/ASTM D 3123-72 using a low-pressure transfer molding machine (KTS-15 manufactured by Kohtaki Corporation), under the conditions of a mold temperature of 175°C, an injection pressure of 6.9 MPa, and a pressure holding time of 120 seconds, and the flow length was measured. Spiral flow is a parameter of fluidity, and a larger value implies more satisfactory fluidity. The unit is cm.

(Gelling time)

A sample formed from each of the epoxy resin compositions for sealing of Examples and Comparative Example was placed on a hot plate set at 175°C, and after the sample melted, the time taken to cure was measured while the sample was kneaded with a spatula. As this time is shorter, it is implied that the curing rate is faster.
The results are shown in Table 2.

(Molding shrinkage rate)

For each of the epoxy resin compositions for sealing of Examples and Comparative Examples, the shrinkage rate was evaluated under the heating conditions (PMC: Post Mold Cure) assuming that a resin composition was subjected to resin sealing (ASM: as Mold) and then to main-curing so as to produce a resin-sealed substrate. First, the dimension of a disc-shaped mold at room temperature was measured at four sites, and the average value was calculated. Subsequently, an epoxy resin composition for sealing was introduced into the mold to obtain a disc-shaped cured product, the diameter at room temperature of the obtained cured product after being heat-treated was measured at four sites corresponding to the sites where measurement was made on the mold, and the average value was calculated. Next, the average value thus obtained was applied to the following formula: [(mold dimension at room temperature - dimension at room temperature of cured product after heat treatment) / mold dimension at room temperature] × 100 (%), and thereby the shrinkage rate $S_n$ (%) of the cured product was calculated.
The results are shown in Table 2. The temperature conditions assuming resin sealing were 175°C and 120 seconds, and the temperature conditions assuming main curing were 175°C and 4 hours.

(Normal temperature elastic modulus / hot elastic modulus)

The hot elastic modulus of a cured product was measured by the following method according to JISK-6911. First, a resin composition for sealing was injection-molded using a low-pressure transfer molding machine ("KTS-15" manufactured by Kohtaki Corporation) at a mold temperature of 175°C, an injection pressure of 6.9 MPa, and a curing time of 120 seconds, and a specimen having a size of 10 mm × 4 mm × 4 mm was obtained. Next, this specimen was heated and measured by a three-point bending method using a DMA analyzer (manufactured by Seiko Instruments, Inc.) in a measurement temperature range of 0°C to 300°C at a rate of 5°C/min, and the normal temperature elastic modulus of the cured product at 25°C and the hot elastic modulus of the cured product at 260°C were measured. The unit is MPa.

(Melt viscosity (rectangular pressure))

A resin composition for semiconductor sealing obtained as described above was injected into a rectangular-shaped flow channel having a width of 15 mm, a thickness of 1 mm, and a length of 175 mm using a low-pressure transfer molding machine (40t manual press manufactured by NEC Corporation), under the conditions of a mold temperature of 170°C and an injection flow rate of 177 $mm^3$/sec, the change in pressure over time was measured with a pressure sensor embedded at a position 25 mm away from the upstream tip of the flow channel, and the lowest pressure during the flow of the resin composition for semiconductor sealing was measured. The rectangular pressure is a parameter of the melt viscosity, and a smaller value implies lower melt viscosity.

(Glass transition temperature, coefficient of linear expansion ($\alpha_1$, $\alpha_2$))

For each Example and each Comparative Example, the glass transition temperature and the coefficient of linear expansion of a cured product of the resin composition for semiconductor sealing thus obtained were measured as follows. First, a resin composition for semiconductor sealing was injection-molded using a transfer molding machine

at a mold temperature of 175°C, an injection pressure of 9.8 MPa, and a curing time of 3 minutes, and a specimen having a size of 15 mm × 4 mm × 4 mm was obtained. Next, the specimen thus obtained was post-cured at 175°C for 4 hours, and then measurement was performed using a thermomechanical analyzer (manufactured by Seiko Instruments & Electronics, Ltd., TMA100) under the conditions of a measurement temperature range of 0°C to 320°C and a rate of temperature increase of 5°C/min. From these measurement results, the glass transition temperature Tg (°C), the coefficient of linear expansion ($\alpha_1$) at a temperature equal to or lower than the glass transition temperature, and the coefficient of linear expansion ($\alpha_2$) at a temperature equal to or higher than the glass transition temperature were calculated. $\alpha_1$ was defined as the coefficient of linear expansion over a range from 40°C to 80°C, and $\alpha_2$ was defined as the coefficient of linear expansion over a range from 190°C to 230°C. The results are shown in Table 2. In Table 2, the unit of $\alpha_1$ and $\alpha_2$ is ppm/°C, and the unit of the glass transition temperature is °C.

(Package warpage)

Semiconductor packages were produced by performing sealing-molding using a low-pressure transfer molding machine and using the resin compositions for sealing of Examples and Comparative Examples at a mold temperature of 175°C, an injection pressure of 6.9 MPa, and a curing time of 2 minutes. These semiconductor devices are ball grid array (BGA) packages (resin-sealed portion size: 35 mm × 35 mm × thickness 1.2 mm), and the chip size is 7 mm × 7 mm. The wire is a gold wire, the wire diameter is 20 μm, and the average wire length is 5 mm. Four packages of each of the semiconductor devices thus obtained were post-cured at 175°C for 4 hours and cooled to room temperature, subsequently the variation in the height direction was measured in a diagonal direction from the gate of the package using a surface roughness meter, the largest value of the variation difference was designated as the amount of warpage, and a case where the average value of the amounts of warpage of the four packages was less than 150 μm was rated as o, while a case where the average value was equal to or more than 150 μm was rated as ×.

Furthermore, the semiconductor packages produced using the resin compositions for sealing of the Examples were also subjected to a reflow treatment under the conditions of 260°C for 10 minutes, and it was confirmed that the average value of the amounts of warpage of the four packages after the reflow treatment was less than 150 μm.

(Wire flow)

The BGA packages formed for the evaluation of the amount of package warpage were observed with a soft X-ray transmission device. As a method for calculating the wire flow amount, when the flow amount of the most flowing (deformed) wire in one package was denoted by (F), and the length of the wire was denoted by (L), the flow amount = F / L × 100 (%) was calculated, and a case where the average value of four packages was less than 5% was rated as ○, while a case where the average value was equal to or more than 5% was rated as ×.

[Table 2]

| | | Example 1 | Example 2 | Example 3 | Example 4 | Example 5 | Example 6 | Example 7 | Example 8 | Example 9 | Comparative Example 1 |
|---|---|---|---|---|---|---|---|---|---|---|---|
| Normal temperature elastic modulus E1 | MPa | 23000 | 22200 | 20800 | 20100 | 23700 | 25100 | 25800 | 11400 | 22700 | 22000 |
| Hot elastic modulus E2 | MPa | 1200 | 1100 | 1000 | 910 | 1290 | 1410 | 1520 | 70 | 950 | 1300 |
| Melt viscosity | MPa | 0.16 | 0.15 | 0.15 | 0.13 | 0.17 | 0.19 | 0.19 | 0.17 | 0.54 | 0.19 |
| Coefficient of linear expansion $\alpha 1$ | ppm/°C | 11.0 | 11.6 | 12.0 | 12.4 | 10.4 | 9. 9 | 9.6 | 23 | 6.2 | 11.5 |
| Coefficient of linear expansion $\alpha 2$ | ppm/°C | 34.4 | 36.2 | 38.3 | 40.1 | 32.5 | 30.5 | 28.7 | 84 | 28 | 35.0 |
| Glass transition temperature Tg | °C | 143 | 144 | 143 | 142 | 145 | 140 | 143 | 149 | 175 | 125 |
| $E2 \times (\alpha_2 \times 10^{-6}) \times (175 - Tg) \times \eta_2$ | | 0.21 | 0.19 | 0.18 | 0.16 | 0.21 | 0.29 | 0.27 | 0.02 | 0 | 0.43 |
| Fluidity (SF) | cm | 126 | 135 | 148 | 153 | 120 | 109 | 94 | 88 | 100 | 127 |
| Gelling time | sec | 33 | 34 | 33 | 33 | 32 | 33 | 34 | 55 | 40 | 33 |
| Molding shrinkage rate (ASM) | % | 0.147 | 0.159 | 0.164 | 0.175 | 0.138 | 0.12 | 0.119 | 0.54 | 0.06 | 0.184 |
| Molding shrinkage rate (PMC) | % | 0.137 | 0.147 | 0.16 | 0.165 | 0.129 | 0.116 | 0.103 | 0.56 | -0.09 | 0.162 |
| Wire flow | | ○ | ○ | ○ | ○ | ○ | ○ | ○ | ○ | ○ | × |
| Package warpage | | ○ | ○ | ○ | ○ | ○ | ○ | ○ | ○ | ○ | × |

This application claims priority on the basis of Japanese Patent Application No. 2018-244444, filed on December 27, 2018, the disclosure of which is incorporated herein in its entirety by reference.

## Claims

1. A resin composition for sealing comprising:

(A) an epoxy resin;
(B) a curing agent; and
(C) a filler,
wherein the epoxy resin (A) includes an epoxy resin (A-1) having a naphthyl ether skeleton, and
wherein the resin composition for sealing satisfies the following Formula (1):

$$\text{Formula (1)}\quad E_2 \times (\alpha_2 \times 10^{-6}) \times (175 - Tg) \times \eta_2 \leq 0.3$$

wherein, in Formula (1), Tg (°C) is a glass transition temperature of a cured product of the resin composition for sealing,
$\alpha_2$ (ppm/°C) is a coefficient of linear expansion over a range from 190°C to 230°C of the cured product, and
$E_2$ (MPa) is a hot elastic modulus at 260°C of the cured product, and
$\eta_2$ (MPa) is a rectangular pressure at 175°C of the resin composition for sealing as measured by the following method;
(method)
the resin composition for sealing is injected, using a low-pressure transfer molding machine, into a rectangular-shaped flow channel having a width of 15 mm, a thickness of 1 mm, and a length of 175 mm under conditions of a mold temperature of 170°C and an injection flow rate of 177 $mm^3$/sec, a change in pressure over time is measured with a pressure sensor embedded at a position 25 mm away from an upstream tip of the flow channel, a lowest pressure (MPa) during a flow of the resin composition for sealing is measured, and the lowest pressure is regarded as the rectangular pressure.

2. The resin composition for sealing according to claim 1, wherein the epoxy resin (A) includes an epoxy resin (A-2) other than the epoxy resin (A-1) having a naphthyl ether skeleton.

3. The resin composition for sealing according to claim 1 or 2, wherein a content of the epoxy resin (A-1) having a naphthyl ether skeleton included in the resin composition for sealing is 1 part by mass to 70 parts by mass with respect to 100 parts by mass of the epoxy resin (A).

4. The resin composition for sealing according to any one of claims 1 to 3, wherein the epoxy resin (A-1) having a naphthyl ether skeleton includes at least one compound represented by the following General Formula (NE):

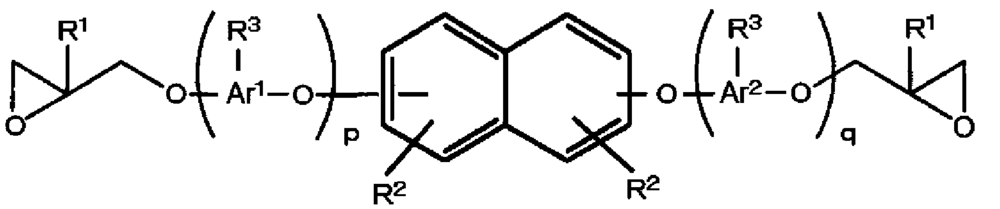
(NE)

wherein, in the General Formula (NE), $R^1$'s each independently represent a hydrogen atom or a methyl group; $Ar^1$ and $Ar^2$ each independently represent a naphthylene group or a phenylene group, where the two groups may each have an alkyl group having 1 to 4 carbon atoms or a phenylene group as a substituent; $R^2$'s each independently represent a hydrogen atom, an alkyl group having 1 to 4 carbon atoms, or an aralkyl group; p and q each independently represent an integer of 0 to 4, provided that either p or q is equal to or more than 1; and $R^3$'s each independently represent a hydrogen atom, an aralkyl group, or an epoxy group-containing aromatic hydrocarbon group.

5. The resin composition for sealing according to any one of claims 1 to 4, wherein a content of the filler (C) included in the resin composition for sealing is 65 parts by mass to 98 parts by mass with respect to 100 parts by mass of

the resin composition for sealing.

6. The resin composition for sealing according to any one of claims 1 to 5, wherein the curing agent (B) includes at least one selected from a phenolic curing agent, an amine-based curing agent, an acid anhydride-based curing agent, and a mercaptan-based curing agent.

7. The resin composition for sealing according to any one of claims 1 to 6, wherein a content of the curing agent (B) included in the resin composition for sealing is 30 to 70 parts by mass with respect to 100 parts by mass of the epoxy resin (A).

8. A semiconductor device comprising a seal resin formed by curing the resin composition for sealing according to any one of claims 1 to 7.

9. A method for producing a semiconductor device, comprising:

a step of mounting a semiconductor element over a substrate; and
a sealing step of sealing the semiconductor element using the resin composition for sealing according to any one of claims 1 to 7.

10. The method for producing a semiconductor device according to claim 9, further comprising a reflow step after the sealing step.

11. The method for producing a semiconductor device according to claim 10, wherein a reflow temperature in the reflow step is equal to or higher than 200°C.

FIG. 1

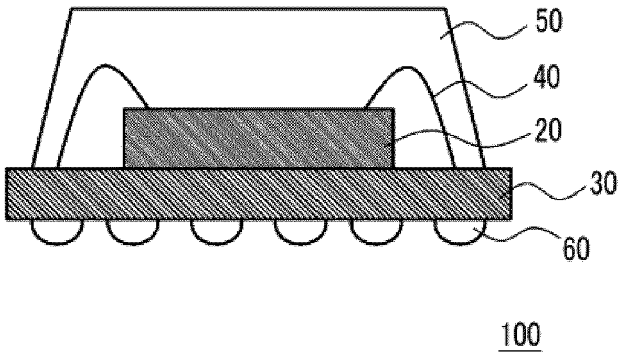


FIG. 2

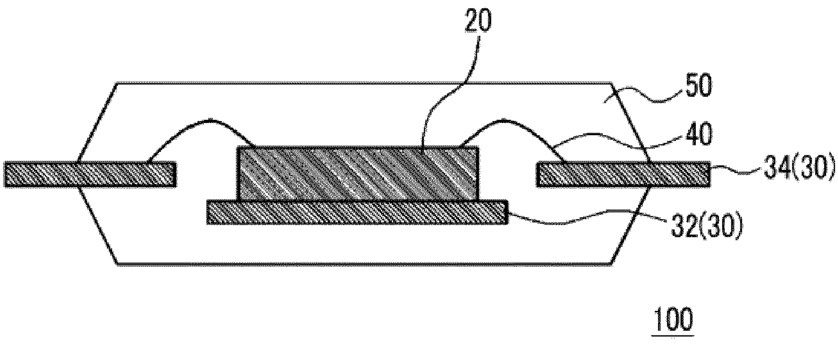

## INTERNATIONAL SEARCH REPORT

International application No.
PCT/JP2019/050401

A. CLASSIFICATION OF SUBJECT MATTER
C08G 59/20(2006.01)i; H01L 23/29(2006.01)i; H01L 23/31(2006.01)i; C08L 63/00(2006.01)i; H01L 21/56(2006.01)i
FI: C08L63/00 C; C08G59/20; H01L23/30 R; H01L21/56 T
According to International Patent Classification (IPC) or to both national classification and IPC

B. FIELDS SEARCHED
Minimum documentation searched (classification system followed by classification symbols)
C08G59/20; H01L23/29; H01L23/31; C08L63/00; H01L21/56

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2017-043649 A (SUMITOMO BAKELITE CO., LTD.) 02.03.2017 (2017-03-02) claims 1-3, 6, 11, paragraphs [0015]-[0024], [0026], [0032]-[0034], [0068]-[0082], example 2 | 1-8<br>9-11 |
| X<br>A | WO 2018/083885 A1 (SUMITOMO BAKELITE CO., LTD.) 11.05.2018 (2018-05-11) claims 1-2, 14-17, 19, paragraphs [0015]-[0010], [0018]-[0019], [0025]-[0029], [0053], [0063]-[0086], example 9 | 1-3, 5-11<br>4 |
| X | JP 2006-307162 A (DAINIPPON INK AND CHEMICALS, INCORPORATED) 09.11.2006 (2006-11-09) claims 1, 5, paragraphs [0033]-[0035], [0070]-[0072], [0127]-[0128], [0142]-[0156], examples 11-19 | 1-11 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 March 2020 (02.03.2020) | 24 March 2020 (24.03.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No. PCT/JP2019/050401

C (Continuation). DOCUMENTS CONSIDERED TO BE RELEVANT

| Category* | Citation of document, with indication, where appropriate, of the relevant passages | Relevant to claim No. |
|---|---|---|
| P, X | JP 2019-182891 A (AJINOMOTO CO., INC.) 24.10.2019 (2019-10-24) claims 1, 5, 10, paragraphs [0013], [0021], [0054], [0119]-[0150], example 3 | 1-11 |

Form PCT/ISA/210 (continuation of second sheet) (January 2015)

**INTERNATIONAL SEARCH REPORT**
Information on patent family members

International application No.
PCT/JP2019/050401

| Patent Documents referred in the Report | Publication Date | Patent Family | Publication Date |
|---|---|---|---|
| JP 2017-043649 A | 02 Mar. 2017 | (Family: none) | |
| WO 2018/083885 A1 | 11 May 2018 | US 2019/0256647 A1 claims 1-2, 14-17, 19, paragraphs [0025]-[0026], [0029]-[0032], [0043]-[0050], [0081], [0092]-[0149], example 9<br>EP 3536745 A1<br>KR 10-2019-0058648 A<br>CN 109890894 A | |
| JP 2006-307162 A | 09 Nov. 2006 | US 2009/0069490 A1 claims 1, 5, paragraphs [0048]-[0049], [0079]-[0081], [0130]-[0131], [0148]-[0169], examples 11-19<br>CN 101495533 A | |
| JP 2019-182891 A | 24 Oct. 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010084091 A
- JP 5157473 B
- JP 2018244444 A